Europäisches Patentamt

European Patent Office

Office européen des brevets

(11) Publication number: **0 534 354 A1**

## (12) EUROPEAN PATENT APPLICATION

(21) Application number: **92116157.6**

(22) Date of filing: **21.09.92**

(51) Int. Cl.5: **H03H 3/08**, H03H 9/145

(30) Priority: **25.09.91 JP 245644/91**

(43) Date of publication of application:
**31.03.93 Bulletin 93/13**

(84) Designated Contracting States:
**DE FR GB NL**

(71) Applicant: **SUMITOMO ELECTRIC INDUSTRIES, LIMITED**
**5-33, Kitahama 4-chome Chuo-ku**
**Osaka(JP)**

(72) Inventor: **Shikata, Shinichi, c/o Itami Works of Sumitomo**
**Electric Industries, Ltd., 1-1, Koyakita**
**1-chome**
**Itami-shi, Hyogo(JP)**
Inventor: **Nakahata, Hideaki, c/o Itami Works of Sumitomo**
**Electric Industries, Ltd., 1-1, Koyakita**
**1-chome**
**Itami-shi, Hyogo(JP)**
Inventor: **Hachigo, Akihiro, c/o Itami Works of Sumitomo**
**Electric Industries, Ltd., 1-1, Koyakita**
**1-chome**
**Itami-shi, Hyogo(JP)**
Inventor: **Fujimori, Naoji, c/o Itami Works of Sumitomo**
**Electric Industries, Ltd., 1-1, Koyakita**
**1-chome**
**Itami-shi, Hyogo(JP)**

(74) Representative: **Herrmann-Trentepohl, Werner, Dipl.-Ing. et al**
**Herrmann-Trentepohl, Kirschner, Grosse, Bockhorni & Partner Forstenrieder Allee 59**
**W-8000 München 71 (DE)**

(54) **Surface acoustic wave device and manufacturing method thereof.**

(57) A surface acoustic wave device which can operate at higher frequency range is provided by making narrower the electrode width while not degrading reliability of the device. The surface acoustic wave device includes a piezoelectric body 3 and interdigital electrodes 2a and 2b in close contact with the piezoelectric body 3, and the interdigital electrodes 2a and 2b are formed by using focused ion beam. In order to increase the frequency of the device, the piezoelectric body 3 may be formed on a substrate 1 formed of, for example, diamond.

FIG. 2C

# BACKGROUND OF THE INVENTION

## Field of the Invention

The present invention relates to a surface acoustic wave device which can be applied to a high frequency filter, for example, and to a method of manufacturing the same.

## Description of the Background Art

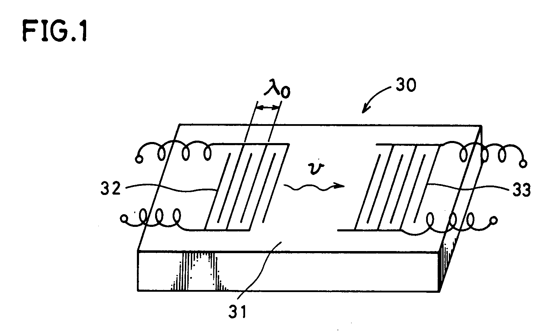

A surface acoustic wave device, which is an electromechanical transducer device utilizing surface waves propagated on the surface of an elastic body, has a general structure shown in Fig. 1, for example. In such a surface acoustic wave device 30, a piezoelectric phenomenon which is caused by a piezoelectric material 31 is utilized for generating surface waves. When an electric signal is applied to one of the interdigital electrodes 32 provided on the piezoelectric body 31, strains are generated in the piezoelectric body 31, which turn to be surface acoustic waves and propagated over the piezoelectric body 31 to be taken out as an electric signal from the other one of the interdigital electrodes 33. The frequency characteristics of the device have the bandpass characteristics with the frequency $f_0$ being the center, which frequency is determined as $f_0 = v/\lambda_0$ where $\lambda_0$ represents the period of the electrodes of the interdigital electrodes and v represents the velocity of the surface acoustic waves.

The surface acoustic wave device can be applied to a filter, a delay line, an oscillator, a resonator, a convolver, a correlator and so on. Especially, a surface acoustic wave filter has been practically applied to an intermediate frequency filter for a television for a long time, while the same is now being applied to filters for VTR and various kinds of communication devices.

With respect to the above described surface acoustic wave device, a device which can be operated at higher frequency range has been desired as a surface acoustic wave filter used in the field of mobile communication, for example. As shown by the above equation, if the period $\lambda_0$ of the electrodes is made smaller or if the velocity v of the surface waves is made higher, the frequency characteristics of the device would have higher center frequency $f_0$. Japanese Patent Laying-Open No. 64-62911 commonly owned by the assignee of this application discloses a surface acoustic wave device in which a piezoelectric body is stacked on a diamond layer so as to increase the velocity v of the surface acoustic waves. The sound velocity in diamond is the highest among all materials known at present, and diamond is physically and chemically stable. Namely, diamond is a material suitable for increasing $f_0$ of the device with high reliability.

Interdigital electrodes have been formed by photolithography. When photolithography technique is employed, it is difficult to make the electrode width smaller than about $0.5\mu m$ because of technical limit of fine processing. The frequency $f_0$ of the device can be made higher by using diamond as mentioned above, while it is necessary to make smaller the electrode width to make smaller the period $\lambda_0$ of the electrodes, if still higher frequency $f_0$ is desired.

# SUMMARY OF THE INVENTION

An object of the present invention is to provide a surface acoustic wave device which can operate at higher frequency with small size electrodes, while maintaining reliability of the device.

According to one aspect, the present invention provides a surface acoustic wave device including a piezoelectric body and interdigital electrodes in close contact with the piezoelectric body, which device is characterized in that the interdigital electrodes are formed by focused ion beam.

Electrolytic dissociated liquid metal is generally used as an ion source of the focused ion beam. The focused ion beam is utilized for ion implantation, ion beam etching, ion beam lithography, ion beam modification, deposition and the like. Among these techniques, deposition and etching are specifically useful for forming interdigital electrodes.

By the deposition using the focused ion beam, gas molecules absorbed in the surface of the substrate is decomposed by ion beam irradiation, and by depositing thus produced nonvolatile dissociated atoms, the interdigital electrodes can be formed, for example. In this method, dimethylgoldhexafluoroacetylacetonate (DMGFA), for example, is used as the raw material gas, and by irradiating Ar beam (ion source: Ar), an Au film is formed as the electrodes. In the method using DMGFA, Ga beam (ion source: Au-Ga or Ga), He beam (ion source: He) or Au beam (ion source: Au-Ga, Au-Be-Si or Au-Si) may be used instead of the Ar beam. Among the aforementioned beams, Ar beam or Au beam with Au occupying 90% or more is more preferred for deposition.

Meanwhile, in deposition using the focused ion beam, trimethylaluminum (TMA) may be used as the raw material gas. In this case, by irradiating Ar beam, Ga beam, He beam or Au beam to the raw material gas, interdigital electrodes of Aℓ can be formed. As described above, by irradiating focused ion beam to a raw material gas consisting of organometallic compound and depositing the produced metal, interdigital electrodes formed of thin metal film can be provided.

Further, when etching by the focused ion beam is employed, by irradiating the focused ion beam to a conductive layer in a reaction gas atmosphere of $C\ell_2$, $BC\ell_3$, $CHF_3$, $XeC\ell_2$ or $XeF_2$ or the like of about 10mTorr, the conductive layer is etched to provide the interdigital electrodes. From the view point of preventing corrosion of the reaction chamber, $XeF_2$ or $CHF_3$ is preferably used as the reaction gas. Au beam or Ge beam can preferably be used as the focused ion beam for etching. Au beam is more preferred as it has higher etching rate.

The beam diameter of the aforementioned focused ion beam can be made to several ten nm at the smallest, and therefore very small structure (the structure in the order of quarter micron) can be formed by using the focused ion beam. Compared with the non-focused ion beam, current density of the focused ion beam is higher and the beam diameter is smaller. Therefore, when the beam is irradiated to the gas, higher activation rate can be obtained, and formation of electrodes with higher precision is possible. Therefore, the device in accordance with the present invention can have interdigital electrodes formed with the line and space of $0.5\mu m$ at the largest, the formation of which is difficult by the conventional technique. In the device in accordance with the present invention, the interdigital electrodes can have the line and space of about $0.1 - 0.5\mu m$ and, more preferably, the line and space of $0.2 - 0.35\mu m$, with high reliability.

In the present invention, the piezoelectric body may include, as the main component, one or more compounds selected from the group consisting of $ZnO$, $A\ell N$, $Pb$ $(Zr, Ti)O_3$, $(Pb, La)(Zr, Ti)O_3$, $LiTaO_3$, $LiNbO_3$, $SiO_2$, $Ta_2O_5$, $Nb_2O_5$, $BeO$, $Li_2B_4O_7$, $KNbO_3$, $ZnS$, $ZnSe$ and $CdS$. The piezoelectric body may be a single crystal or polycrystal. However, single crystal in which the surface waves scatter less is more preferred in order to use the device at higher frequency range. Among these materials, the piezoelectric body of $ZnO$, $A\ell N$ and $Pb$ $(Zr, Ti)O_3$ can be formed by CVD method or by sputtering.

In the device in accordance with the present invention, a material in which the acoustic waves propagate at higher velocity than the piezoelectric body (for example, diamond, diamond-like carbon, boron nitride, sapphire and the like) may be provided in close contact with or adhered on the piezoelectric body. The diamond includes natural single crystal diamond, single crystal diamond artificially synthesized under very high pressure and polycrystalline diamond vapor deposited by CVD, ion beam deposition or by sputtering. The diamond-like carbon is also called i-carbon, which is a composition including carbon and hydrogen. The diamond-like carbon film is an amorphous and electrically an insulator. The diamond-like carbon film transmits light and has a hardness of about 1000 - 5000 (Hv). The diamond-like carbon film is synthesized by the vapor phase process of CVD, ion beam, vapor deposition or sputtering.

According to another aspect, the present invention provides a method of manufacturing a surface acoustic wave device including a piezoelectric body and interdigital electrodes in close contact with the piezoelectric body, which method is characterized in that the interdigital electrodes are formed by using focused ion beam. The interdigital electrodes can be formed by the above mentioned deposition or etching by focused ion beam, for example.

In the manufacturing method of the present invention, interdigital electrodes can be made on a prepared substrate and a piezoelectric body can be formed thereon. The substrate may be formed of a semiconductor such as Si, diamond, sapphire, boron nitride or the like. When a semiconductor substrate of Si or the like is used, a thin film of diamond, diamond-like carbon, sapphire or boron nitride may be formed on the substrate, and the interdigital electrodes may be formed thereon. The thin film may be formed by CVD, ion beam deposition or sputtering. The interdigital electrodes may be formed on a piezoelectric body formed on the substrate.

Since the interdigital electrodes are formed by using the focused ion beam in the surface acoustic wave device of the present invention, the electrode width can be made in the order of quarter micron. The precision of the electrode width is high. Therefore, the device of the present invention can operate at higher frequency range than the prior art, and in addition it has superior reliability. Further, formation of electrodes by the focused ion beam can be effected without mask. More specifically, in the device of the present invention, interdigital electrodes can be directly formed without the step of resist formation, which significantly reduces the number of manufacturing steps. Further, electrode formation by the focused ion beam can be carried out in accordance with the information stored in a computer, and therefore surface acoustic wave devices with custom made electrodes can be easily provided. Therefore, the device of the present invention is suitable for producing various types of devices each type in small number. Further, in the device of the present invention, the interdigital electrodes can be formed of metals which can not be finely processed by the conventional method, such as Au, by means of the focused ion beam. By employing Au for the electrodes, a device having high reliability can be provided.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a plan view showing a general structure of a surface acoustic wave device.

Figs. 2A - 2C are cross sectional views schematically showing the steps of manufacturing a surface acoustic wave device in accordance with one embodiment of the present invention, in which Fig. 2C shows the finished device.

Figs. 3A - 3C are cross sectional views schematically showing the steps of manufacturing the surface acoustic wave device in accordance with another embodiment of the present invention, in which Fig. 3C shows the finished device.

Fig. 4 is a cross sectional view schematically showing a further specific example in accordance with the present invention.

DESCRIPTION OF THE PREFERRED EMBODIMENTS

Embodiment 1

A high frequency filter in accordance with the present invention was manufactured in the following manner.

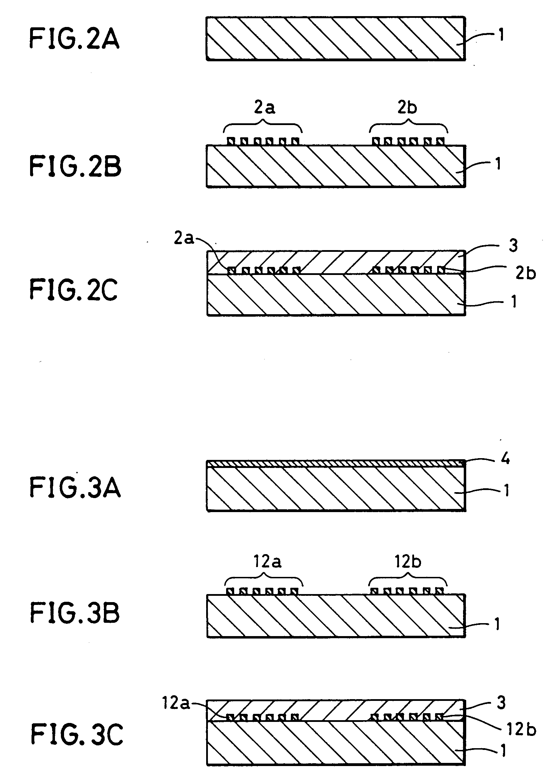

Referring to Fig. 2A, a substrate 1 of a single crystal diamond was prepared. The substrate was placed on a focused ion beam apparatus, and dimethylgoldhexafluoroacetylacetonate (DMGFA) as a source gas was introduced to the substrate 1. Thereafter, Ar beam of 1keV was irradiated on the substrate 1, and by beam scanning, interdigital electrodes 2a and 2b of Au were formed with the line and space of $0.3\mu m$ (Fig. 2B). Thereafter, the substrate on which the electrodes were formed was moved from the focused ion beam apparatus to a magnetron sputtering device, and an ZnO piezoelectric body 3 was deposited on the substrate 1 (Fig. 2C) by magnetron sputtering in which ZnO polycrystalline body was sputtered with a mixed gas of $Ar:O_2 = 1:1$ at the sputter power of 100W and substrate temperature of 380°C. The resonance frequency of the high frequency filter formed in the above described method was 8GHz.

In the above described embodiment, Ga beam (ion source: Au-Ga or Ga), He beam (ion source: He) or Au beam (ion source: Au-Ga, Au-Be-Si or Au-Si) may be used instead of the Ar beam. Further, interdigital electrodes of $A\ell$ can be formed by using trimethylaluminum (TMA) instead of DMGFA in the above described embodiment.

When using Au as shown in the above described embodiment, it is possible to provide a surface acoustic wave device which maintains superior reliability without an electro-migration though having the small line and space such as 0.3 $\mu$m.

Embodiment 2

At layer 4 was vapor-deposited to the thickness of about $700\mu m$ by ohmic-resistance heating on a substrate 1 of single crystal diamond, as shown in Fig. 2(a). Thereafter, the substrate was placed in a reaction chamber of the focused ion beam apparatus, and $Au^+$ ion beam with the ion source of Au-Be-Si was irradiated in $XeF_2$ of 20mTorr. Etching was done by irradiating the $Au^+$ ion beam while scanning the Al layer 4, and as a result, interdigital electrodes 12a and 12b of $A\ell$ were formed which have the line and space of $0.3\mu m$ (Fig. 2(b)). Thereafter, ZnO piezoelectric body 3 was deposited in the similar manner as in embodiment 1 (Fig. 2(c)). The resonance frequency of the high frequency filter formed by the above described method was about 8GHz.

For comparison, interdigital electrodes of $A\ell$ were formed with the line and space of $0.6\mu m$ by conventional photolithography and reactive ion etching on a diamond substrate, and ZnO piezoelectric body was deposited to provide a high frequency filter. The resonance frequency of this filter was 4GHz.

In the above embodiment 2, $C\ell_2$, $BC\ell_3$, $CHF_3$ or $XeC\ell_2$ may be used in place of $XeF_2$. In addition, Ga ion beam may be used instead of the $Au^+$ beam.

From the above embodiments, it is proved that the interdigital electrodes of small line and space which could not be obtained in the prior art can be formed and as a result the device in accordance with the present invention can operate at higher frequency range. Further, by the present invention, interdigital electrodes having desired shapes can be formed without forming resist films.

The present invention enables formation of interdigital electrodes through smaller number of manufacturing steps as compared with the prior art.

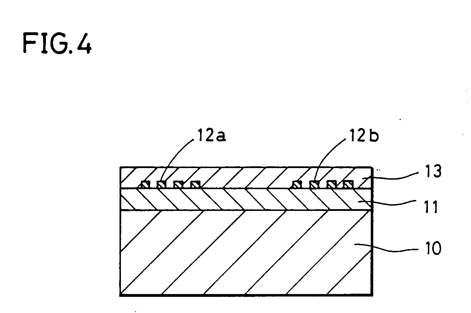

Although a diamond crystal was used as a substrate in the above described embodiments, substrates other than diamond may be used. As shown in Fig. 4, for example, silicon may be used as a substrate 10, a diamond layer 11 may be formed by the CVD method thereon and the interdigital electrodes 12a and 12b and the piezoelectric body 13 may be stacked thereon. Diamond-like carbon film, sapphire or boron nitride may be used instead of diamond.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A surface acoustic wave device including a piezoelectric body and interdigital electrodes in close contact with said piezoelectric body, wherein
   said interdigital electrodes are formed by using focused ion beam.

2. The surface acoustic wave device according to claim 1, wherein
   a material having higher propagation velocity of acoustic waves than said piezoelectric body is adhered on said piezoelectric body.

3. The surface acoustic wave device according to claim 1, wherein
   said material consists essentially of at least one selected from the group consisting of diamond, diamond-like carbon film, sapphire and boron nitride.

4. A surface acoustic wave device including a piezoelectric body and interdigital electrodes in close contact with said piezoelectric body, wherein
   said interdigital electrodes have line and space of about 0.5μm at the largest, and formed by depositing a metal generated by irradiating a focused ion beam to a raw material gas mainly composed of organometallic compound.

5. The surface acoustic wave device according to claim 4, wherein
   said organometallic compound includes gold element, and said interdigital electrodes are essentially formed of gold.

6. The surface acoustic wave device according to claim 4, wherein
   a material having higher propagation velocity of acoustic waves than said piezoelectric body is adhered on said piezoelectric body.

7. The surface acoustic wave device according to claim 6, wherein
   said material consists essentially of at least one selected from the group consisting of diamond, diamond-like carbon film, sapphire and boron nitride.

8. A surface acoustic wave device including a piezoelectric body and interdigital electrodes in close contact with said piezoelectric body, wherein
   said interdigital electrodes have line and space of about 0.5μm at the largest, and is formed by etching a conductive layer by irradiating a focused ion beam to the conductive layer in a reaction gas atmosphere.

9. The surface acoustic wave device according to claim 8, wherein
   said interdigital electrodes are essentially formed of aluminum or gold.

10. The surface acoustic wave device according to claim 8, wherein
    a material having higher propagation velocity of acoustic waves than said piezoelectric body is adhered on said piezoelectric body.

11. The surface acoustic wave device according to claim 10, wherein
    said material consists essentially of at least one selected from the group consisting of diamond, diamond-like carbon film, sapphire and boron nitride.

12. A method of manufacturing a surface acoustic wave device including a piezoelectric body and interdigital electrodes in close contact with said piezoelectric body, wherein,
    said interdigital electrodes are formed by depositing a metal produced by irradiating a focused ion beam to a raw material gas mainly consisting of organometallic compound.

13. The method of manufacturing a surface acoustic wave device according to claim 12, wherein
    said piezoelectric body and said interdigital electrodes are formed on a substrate essentially formed of at least one of diamond, sapphire and boron nitride.

14. The method of manufacturing a surface acoustic wave device according to claim 12, wherein
    said piezoelectric body and said interdigital electrodes are formed of a thin film essentially formed of at least one selected from the group consisting of diamond, diamond-like carbon film, sapphire and boron nitride.

15. The method of manufacturing a surface acoustic wave device according to claim 12, wherein
    said organometallic compound includes gold element, and said interdigital electrodes are essentially formed of gold.

16. The method of manufacturing a surface acoustic wave device according to claim 12, wherein said focused ion beam includes ion of any of Ar, Ga, He and Au.

17. A method of manufacturing a surface acoustic wave device including a piezoelectric body and interdigital electrodes in close contact with said piezoelectric body, wherein said interdigital electrodes are formed by etching a conductive layer by irradiating a focused ion beam to said conductive layer in a reaction gas atmosphere.

18. The method of manufacturing a surface acoustic wave device according to claim 17, wherein said piezoelectric body and said interdigital electrodes are formed on a substrate essentially formed of at least one of diamond, sapphire and boron nitride.

19. The method of manufacturing a surface acoustic wave device according to claim 17, wherein said piezoelectric body and said interdigital electrodes are formed on a thin film essentially formed of at least one selected from the group consisting of diamond, diamond-like carbon film, sapphire and boron nitride formed on a substrate.

20. The method of manufacturing a surface acoustic wave device according to claim 17, wherein said reaction gas consists essentially of any of the compound selected from the group consisting of $XeF_2$, $C\ell_2$, $BC\ell_3$, $CHF_3$ and $XeC\ell_2$, and wherein said focused ion beam includes ion of Au or Ge.

FIG.1

FIG.2A

FIG.2B

2a     2b

FIG.2C

2a      3

2b

1

FIG.3A

4

1

FIG.3B

12a    12b

1

FIG.3C

12a      3

12b

1

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | US-A-4 638 536 (J.R.VIG) <br> * the whole document * <br> --- | 1,17 | H03H3/08 <br> H03H9/145 |
| Y | US-A-4 874 460 (YOSHITOMO NAKAGAWA) <br> * column 2, line 27 - column 2, line 34; figure 1 * <br> * column 3, line 45 - column 3, line 52 * <br> * column 4, line 42 - column 4, line 48 * <br> --- | 1,17 | |
| A | EP-A-0 407 163 (MURATA) <br><br><br> * column 1, line 15 - column 1, line 29 * <br> * column 4, line 9 - column 4, line 13 * <br> --- | 2,3,6,7, 10,11, 13,18,19 | |
| A | PATENT ABSTRACTS OF JAPAN <br> vol. 006, no. 057 (C-098)14 April 1982 <br> & JP-A-56 169 771 ( AGENCY OF IND SCIENCE & TECHNOL ) 26 December  1981 <br> * abstract * <br><br> ----- | 5,9,15 | |
| | | | **TECHNICAL FIELDS SEARCHED (Int. Cl.5 )** <br><br> H03H |

The present search report has been drawn up for all claims

| Place of search | Date of completion of the search | Examiner |
|---|---|---|
| THE HAGUE | 30 NOVEMBER 1992 | COPPIETERS C. |